(19) Europäisches Patentamt / European Patent Office / Office européen des brevets

(11) **EP 2 239 792 A1**

(12) **EUROPEAN PATENT APPLICATION**

(43) Date of publication:
**13.10.2010 Bulletin 2010/41**

(51) Int Cl.:
*H01L 41/08* (2006.01)          *G02B 7/08* (2006.01)
*G02B 6/42* (2006.01)

(21) Application number: **09157508.4**

(22) Date of filing: **07.04.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**

(71) Applicants:
• **Universität Potsdam**
  **14469 Potsdam (DE)**
• **Fraunhofer-Gesellschaft zur Förderung der angewandten Forschung e.V.**
  **80686 München (DE)**

(72) Inventors:
• **Kofod, Guggi**
  **10961, Berlin (DE)**
• **McCarthy, Denis**
  **10245, Berlin (DE)**
• **Jordan, Grace**
  **10243, Berlin (DE)**

(74) Representative: **Gulde Hengelhaupt Ziebig & Schneider**
  **Patentanwälte - Rechtsanwälte**
  **Wallstrasse 58/59**
  **10179 Berlin (DE)**

(54) **Positioning device and use of the same**

(57)    The invention concerns about a positioning device using one or more actuators, especially a positioning device useful for positioning of optical fibers. According to one aspect of the present invention, there is provided a positioning device comprising:
(i) at least one actuator induing
- a dielectric elastomer film;
- a frame adapted for supporting the film;
- a through-hole placed in a central region of the film;
- one or more compliant front electrodes applied planar to a front side of the film and one or more compliant back electrodes applied planar to a back side of the film, wherein each one of the front electrodes is configured such that a circular section of the film starting from the through-hole is not applied to said one front electrode; and

(ii) a circuit electrically connected to the front and back electrodes of the at least one actuator and being adapted for applying a voltage across the film via the front and back electrodes.

Fig. 3

## Description

The invention concerns about a positioning device using one or more actuators, especially an positioning device useful for positioning of optical fibers.

## Technological Background and State of Art

In several technical fields highly sensitive multi-dimensional positioning of rod-like members is necessary. For example, currently, optical modules containing single mode micro-optical components require the optical alignment to be carried out manually by a trained operator using a high-precision piezoelectric positioning stage. Alternatives to this manual alignment have been proposed and implemented. These alternatives can be grouped into two types of approach. The first of these approaches maintains the use of external alignment but replaces the human operator with specially designed robotic equipment and optical sub-mounts while the second approach uses sub-mounts which themselves are actuated and would be used in combination with standard assembly methods for initial alignment followed by fine alignment with the integrated actuators.

A more thorough description of the state of the art in both of these approaches is as follows:

Axsun Corporation has automated the alignment and assembly process using an innovative technique based on the plastic deformation of LIGA MEMS component sub-mounts by a robotic arm after initial assembly and passive alignment steps. This method allows a large range of positions and fine alignment to be achieved however the initial investment in specialized equipment and large number of custom components limits the cost-effective implementation of this approach. Intel Corporation have developed a similar technology whereby the sub-mounts are also plastically deforming metal holders however they are not LIGA MEMS devices making them cheaper. However Intel's approach also requires large capital investment and setup costs.

An alternative to the use of external manipulation to precisely position components is to integrate positioning elements into the package or component itself. This allows cost-effective manufacturing techniques that are standard in electronics manufacturing, such as surface mount technology, to be employed for initial package assembly, with the subsequent engagement of integrated realignment devices to achieve the final required precision. A considerable body of work already exists in the development of integrated actuators for micro-optical components, which is focussed predominantly on the use of MEMS actuators and positioners. Examples of such MEMS devices are 1-dimensonal fibre positioners, beam-steering devices based on MEMS scratch drive actuators, and electrostatically actuated steering mirrors.

While MEMS actuators are effective in achieving the alignment precision required for optical packaging applications, they suffer from several drawbacks, namely costly and complex fabrication requirements and reliability issues associated with their often-intricate structure. Furthermore, the operating requirements in terms of voltage and power consumption are prohibitive. For example, electrothermal based devices often require several watts of power to align an individual optical fibre.

## Summary of Invention

It is an aim of the present invention to solve or at least lessen one or more of the above mentioned technical problems.

According to one aspect of the present invention, there is provided a positioning device comprising:

(i) at least one actuator including

- a dielectric elastomer film;

- a frame adapted for supporting the film;

- a through-hole placed in a central region of the film;

- one or more compliant front electrodes applied planar to a front side of the film and one or more compliant back electrodes applied planar to a back side of the film, wherein each one of the front electrodes is configured such that a circular section of the film starting from the through-hole is not applied to said one front electrode; and

(ii) a circuit electrically connected to the front and back electrodes of the at least one actuator and being adapted for applying a voltage across the film via the front and back electrodes.

Preferably, the actuator includes 4 front electrodes extending form the through-hole in equally sized circular sections. According to another preferred embodiment, the positioning device includes at least 2 actuators being arranged in line.

Preferably, the dielectric elastomer film is pre-strained. Pre-straining the film before fixing it in the frame, leads to greater motion at lower voltages. This is an advantage because it allows the device to operate at lower voltages than that operating in an un-prestrained state.

According to another preferred embodiment, the circuit is electrically connected to the front and back electrodes via flexible interconnections. When flexible electrical interconnections are used, the electrical contact remains stable and reliable as the film and electrodes move. This is an advantage as it ensures reliable operation over a wide range of positions.

Preferably, the dielectric film and the corresponding front electrodes are distended in a direction perpendicular to the plane of the actuator. The positioning device may include two distended actuators placed back to back or the tops of the distended actuators may be forced together.

According to another aspect of the invention, the above mentioned positioning device is used for the positioning of an object for any purpose, especially for the alignment of optical fibres in telecommunication modules or other optical packages.

According to other aspects of the invention, the above mentioned positioning device is used in medical devices, in an apparatus for position sensing of an object, in switching applications or in adaptive optics applications.

The current invention thus describes a micropositioning device which operates in several dimensions and is based on dielectric elastomer actuators (DEA) with compliant electrodes. The device itself has advantages over conventional actuators in terms of cost, weight, design and performance and operating characteristics such as low power dissipation.

In summary, some of the advantages of this invention are

- Multi-dimensional positioning/actuation is achieved (in the most important directions for optical component alignment.) and this is achieved without the use of complex hinge or gimbal structures which for small scale devices are typically MEMS devices that are expensive to produce and prone to unreliable operation.

- The inventive positioning device has advantages over commonly used piezoelectric crystals in terms of % strain, weight, cost and manufacturing complexity since there are no epitaxially grown piezoelectric crystals used.

- The materials used for the inventive positioning device are light-weight, and inexpensive allowing a low-cost solution to the problem of fine positioning and the possibility of integration at a system, chip or package level since no heavy material is used.

- The inventive positioning device is easily scalable. This will allow integration into optical packages at the substrate or package level and thus the integration of realignment into a package itself making external alignment using manual or robotic techniques unnecessary. This type of manufacturing paradigm is a parallel process which uses existing high speed electronic manufacturing infrastructure plus integrated alignment capabilities to produce many modules in parallel. It will be expected to lead to large manufacturing cost reduction.

- The inventive positioning device is insensitive to sideways torques. This is an advantage as the position perpendicular to the actuator face remains well-defined, controlled and extremely precise.

An intended application of this invention may be the sub-micron precision positioning of micro-optical components (such as single mode optical fibres) to maximise optical coupling between them but can however be applied to any component which should be positioned precisely with several degrees of freedom and using a small, light, dynamic cost-effective technology. In addition to this, the device can sense external forces which would also alter its position leading to a "smart" positioning device. Further examples of use for the inventive positioning device include components for directing and/or controlling other types of electromagnetic radiation of other frequency, micro-channels, components used in medical devices such as catheters, in molecular-biological investigations, in chip-level component and device investigation, or in microscopy generally where precise sample position is necessary.

An important application of the invention is foreseen as a component in a manufacturing system for optical packages. Since the breakthrough of fibre-optic telecommunications systems, the production of cost-effective single-mode optical modules has been hampered by the packaging of such modules. Unlike in the semiconductor electronics industry, where packaging accounts for a very small proportion of the cost of production, the packaging costs of optoelectronic devices can comprise up to 80 % of the cost of goods (COG). There are two main drivers for this high cost, namely very high precision positioning requirements of single-mode optical components and the need for hermetic packaging to protect optical surfaces from environmental damage. The aim of this invention is among others to address the first of these important issues, namely that of high-precision but low-cost positioning of single-mode optical components in photonic packages. The present invention allows a more cost-effective production of modules as well as improved performance of these modules due to higher light throughput.

The inventive positioning device may be used for sub-micron precision positioning of micro-optical components (such as single mode optical fibres) to maximise optical coupling between them but can however be applied to any component which should be positioned precisely with several degrees of freedom and using a small, light, dynamic cost-effective technology. In addition to this, the device can sense external forces which would also alter its position leading to a "smart" positioning device. Examples of other possible applications are for directing and/or controlling other types of electromagnetic radiation of other frequency, micro-channels, components used in medical devices such as catheters, in molecular-biological investigations, in chip-level component and device investigation, or in microscopy generally where precise sample position is necessary. in other words, the current invention thus describes a micro-positioning device which operates in several dimensions and is based on dielectric elastomer actuators (DEA) with compliant electrodes. The device itself has advantages over other actuators in terms of cost, weight, design and performance and operating characteristics such as low power dissipation.

In summary, the following application areas for the inventive positioning device are favoured at present:

- Micro-optical component positioning for telecommunications module manufacture

- Micro-optical component positioning for optical packages in sensor applications and other modules where micro-optical components are used such as on data communications and modules using silicon photonics or high refractive index waveguides.

- Adaptive optics applications

- In switching applications, especially where electromagnetic radiation is directed in a particular direction.

- Medical components where precise mufti-dimensional positioning is required for example in catheters, in-situ pumps

- Highly sensitive 3D position sensing of a rod-like object via capacitive sensing. In general, where 3D positioning is required of a rod-like object: optical sensors, mirrors, lenses and/or sources; direction-sensitive passive and/or active antennas for electromagnetic waves; electron, proton, x-ray and/or gamma-ray sources; directional molecular, nuclear and/or sub-nuclear particle sensors; single segments of segmented mirrors, such as for astronomical purposes; solar and/or electro-magnetic wave reflectors; acoustic sensors and/or sound sources; ultra-sonic sensors and/or sound sources; liquid or powder or dust or spray coating devices; mass-accelerating weapons, kinetic weapons, electromagnetic wave weapons, acoustic or ultra-sonic weapons, solar reflecting weapons, and other weapons.

- A strong and highly mobile electrically active joint for use in robotics (locomotion, manipulation) with many possibilities for accurate control.

**Brief Description of the Drawings**

The invention will now be described in more detail by means of examples and the corresponding figures. These figures illustrate:

Figure 1 shows an positioning device according to one embodiment of the invention.

Figures 2 to 16 show positioning devices according to further embodiments of the invention.

**Detailed Description**

The inventive positioning device comprises:

(i) at least one actuator including

- a dielectric elastomer film;

- a frame adapted for supporting the film;

- a through-hole placed in a central region of the film;

- one or more compliant front electrodes applied planar to a front side of the film and one or more compliant back electrodes applied planar to a back side of the film, wherein each one of the front electrodes is configured such that a circular section of the film starting from the through-hole is not applied to said one front electrode; and

(ii) a circuit electrically connected to the front and back electrodes of the at least one actuator and being adapted for applying a voltage across the film via the front and back electrodes.

Dielectric elastomers (DEs) are smart material systems which produce large strains (up to 300%) and belong to the group of electroactive polymers (EAP). Based on their simple working principle dielectric elastomer actuators (DEA) transform electric energy directly into mechanical work. DEs are lightweight, have a high elastic energy density and are investigated since the late 90's. A DEA is a compliant capacitor, where a passive elastomer film is sandwiched between two compliant electrodes. When a voltage U is applied, the electrostatic pressure $p_{el}$ arising from the Coulomb forces acting between the electrodes. Therefore the electrodes squeeze the elastomer film. The equivalent electromechanical pressure $p_{eq}$ is twice the electrostatic pressure $p_{el}$ and is given by the following equation:

$$p_{eq} = \varepsilon_0 \varepsilon_r \frac{U^2}{z^2}$$

where $\varepsilon_0$ is the vacuum permittivity, $\varepsilon_r$ is the dielectric constant of the polymer and z is the thickness of the elastomer film. Usually, strains of DEA are in the order of 10-35%, maximum values are up to 300%. For the elastomer often silicones and acrylic elastomers are used. In particular, the acrylic elastomer VHB 4910, commercially available from the company 3M has shown the largest activation strain (300%), a high elastic energy density and a high electrical breakdown strength. Basically, the requirements for an elastomer material for DEA are that the material should have a low stiffness (especially when large strains are required), the dielectric constant should be high and the electrical breakdown strength should be high. A possibility to enhance the electrical breakdown strength is to pre-stretch the elastomer film mechanically. Further reasons for pre-stretching the elastomer are that the thickness of the film decreases, a lower voltage has to be applied to obtain the same electrostatic pressure, the pre-strain avoids compressive stresses in the film plane directions which might be responsible for failure, and the elastomers show a visco-hyperelastic behavior. An positioning device that uses multiple electrode regions on a pre-stretched dielectric elastomer actuator film has a different geometry but operates on the same principle.

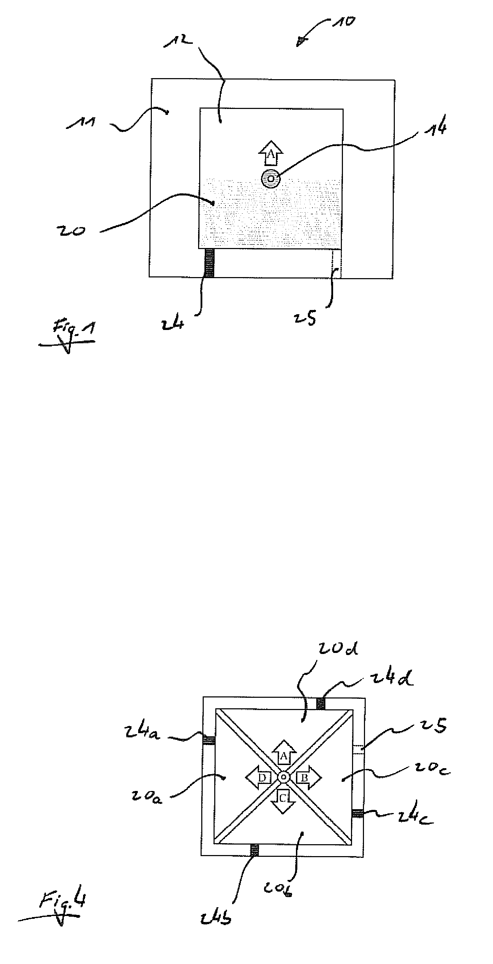

Preferably, one or more dielectric elastomer films may be added to the presented positioning devices. For instance, in figure 1, an identical elastomer film with identical alignment of the electrodes can be placed directly on top of the elastomer film already provided, without altering its function. Such an additional film can, however, lead to improved functionality if, say, a device was made with two thinner elastomer films, than one thick, since this would lower the operating voltage. Also, if it is specifically sought to add more films (as described above) the use of film stacking can reduce the technical complication. It is essential that stacking of more elastomer films is considered as it would improve the performance but in principal would not change the operating principle.

As to the electrodes, several different types of electrodes can be used (e.g. graphite powder, silicone oil / graphite mixtures, gold electrodes, etc.). The electrode should be conductive and compliant. The compliance of the electrode is important in order that the elastomer is not constrained mechanically in its elongation by the electrode. Materials useful for establishing the electrodes are known in the prior art.

One or more compliant front electrodes are applied planar to a front side of the film and one or more compliant back electrodes are applied planar to a back side of the film. At least each one of the front electrodes - may be also each one of the back electrodes - is configured such that a circular section of the film starting from the through-hole is not applied to a front electrode (and a back electrode). In other words, each of the electrodes has a shape and is positioned such on the film that is does not cover a region of the film all around the through-hole. It is an important aspect of the working principle of this actuator that the activated electrode only covers a part of the elastomer. Hence, applying a voltage to such a front electrode and a corresponding back electrode lying on the opposite side of the film causes a contraction of the film between the electrodes and, respectively, a movement of the through-hole in direction of the areas not covered by the front electrode. A circular section in the sense of the invention does not necessarily mean that the film has circular shape; the film may have other shapes. Circular section thus should be interpreted in that way that it refers to an area of the film extending from the central through-hole in radial direction where the distinct electrode(s) to which a voltage is applied are not arranged.

The electrical interconnections from the outside electrical amplifiers (the circuit) to the electrodes on the elastomer film may be flexible interconnections. When flexible electrical interconnections are used, the electrical contact remains stable and reliable as the film and electrodes move. This is an advantage as it ensures reliable operation over a wide range of positions. Materials useful for establishing the electrical interconnections are known in the prior art.

The issue of electrical cross-talking between the electrodes may be avoided for example by coating the outermost electrodes with a passive elastomer film identical to the lower one(s), or by coating all electrodes with a thin elastomer solution or gel.

The positioning device may include several electrode regions, but in which the grounded regions are not all connected to the same ground. In principle, all individually identifiable actuator regions can be driven electrically independent of each other provided the amplifiers are electrically independent.

The frame fixes the position of the dielectric elastomer film. The accurate shape and size of the outside frame could be altered. Below, frames of a square and circular inner shape are presented. However, the outer shape and the inner shape can be varied from these shapes, and still provide a solution with similar qualities but that fits physically more readily in a particular application. Any plastic, wood or other non- or low conducting material can be used for the frames.

In the central through-hole a holder member may be placed. The holder member provides a mechanical release of the film, to avoid film rupture, and to hold the object to be moved. The accurate shape and size of this holder member could be altered. It is of course possible to avoid the use of this member by choice of elastomers which do not rupture, or by locally infusing the elastomer film with another liquid material which will solidify later on. In principle the any type of holder could be used as this does not affect the operating mechanism.

In the following, distinct embodiments are presented for illustrative purposes. However, the exact arrangement, combination, position, individual shape and holding members for the realization of the devices presented in figures can be modified in view of other applications. For example, between two opposing frames many types and structures can be placed: separating tubes, screws, frame pieces, mirrors, etc. There is an infinity of ways that one can choose between the actuators presented below, their various improvements (as discussed: electrode and frame structure and arrangement, stacking, etc.), the various number and interposition, to obtain an infinity of devices with 3D motion of some practical usefulness.

Further, the positioning devices based on the principle of invention could be as large as several tens of meters and as small as a few mm's or even smaller. The realisation of very small or very large devices is one of access or availability of certain technologies such as methods for applying electrodes, manufacturing frames and assembly on a large or small scale. The size of the device should not play a role. A whole spectrum of sizes would all function on the same principle.

The most basic embodiment of an inventive positioning device including an actuator 10 is depicted in Fig. 1.

It consists of a plastic frame 11 which comprises a front face section and a back face section and these two laminar pieces fit together leaving an area of free space between them. A dielectric elastomer film 12 is placed in either a relaxed mechanical state or having been previously pre-stretched over one piece of the frame 11 and the other piece of the frame 11 is attached from the other side creating a sandwich structure where the central portion of the device is the dielectric elastomer film 12. In the centre of this section, a small holder member 14 is placed via an incision in the dielectric elastomer film 12. This is carried out in such a way that the dielectric elastomer film 12 in its central section is completely free of material (has a through-hole).

Below or above the holder member 14, compliant electrodes are applied to both sides of the central film 12. Here, a front electrode 20 is shown. On the opposite side of the film 12 a back electrode is applied (not shown). These electrodes can be any type of compliant electrodes which can be applied before or after pre-stretching if pre-stretching is used. Examples of possible electrode materials are metal foil, metal foils which are patterned via UV lithography, conducting particle matrices, including those where the matrix is a rubber, gel, oil or ionic liquid. The electrodes can take many shapes as long as the electrode material does not cover the entire surface of the dielectric film.

Flexible interconnections 24 and 25 are made to the front and back electrode. Upon application of a voltage, there is an attraction of the electrodes across the film thickness which causes the film 12 to contract in thickness and correspondingly expand laterally. This action causes a deflection of the central holder member 14 in the vertical direction the magnitude of which depends on applied voltage. When, for example, a micro-optical component like a single mode fibre, other micro-optical component, or other component requiring high precision positioning is placed in the central holder member 14 it can be positioned with high accuracy in the vertical direction planar to the frame 11.

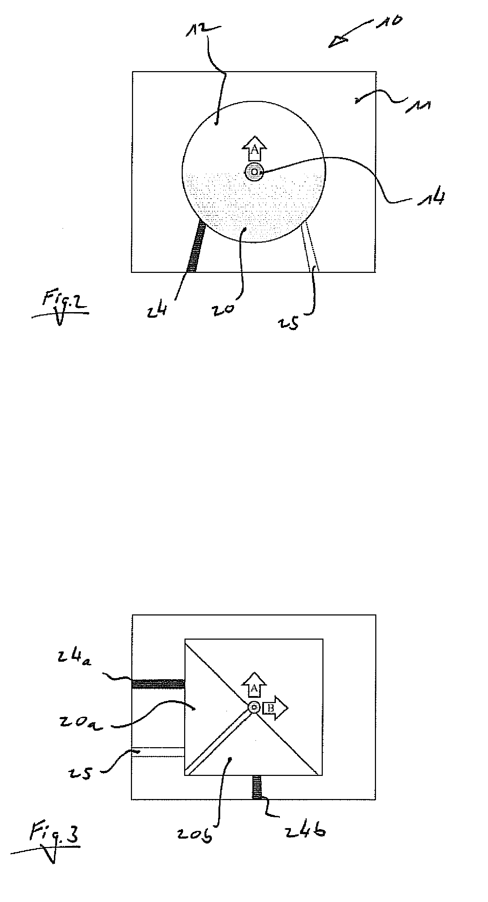

A similar actuator 10 which operates in the same manner but has a different geometry of the frame 11 is depicted in Fig. 2.

Fig. 3 depicts another actuator 10 useful for performing 2-dimensional alignment in the two lateral directions planar with the face of the actuator 10. The actuator 10 comprises a plastic frame 11, a dielectric elastomer film 12, compliant front electrodes 20a and 20b, flexible electrical interconnections 24a, 24b, 25 and a central holder member 14 to accommodate a micro-optical component or other component. This device achieves 2-dimensional lateral motion as follows. By application of a voltage via electrical interconnections 24b and 25 to the front electrode 20b and the back electrode (not shown) a compression of the dielectric film 12 in this region is caused and results in an upward movement of the central holder member 14 in the direction marked A by the arrow. Similarly, the application of a voltage to front electrode 20a and the back electrode (not shown) would result in a motion in the direction marked B.

In this way 2-dimensional motion in the plane of the frame 1 can be achieved. When a micro-optical component such as an optical fibre is placed in the central holder member 14, this movement can align the fibre in the two lateral directions parallel to its length which could be used to optimise coupling between the micro-optic component and another component such as a laser diode, fibre or lens. This type of motion is the most important and sensitive in the alignment of single mode optical components. The same device could align any device or component in 2 dimensions.

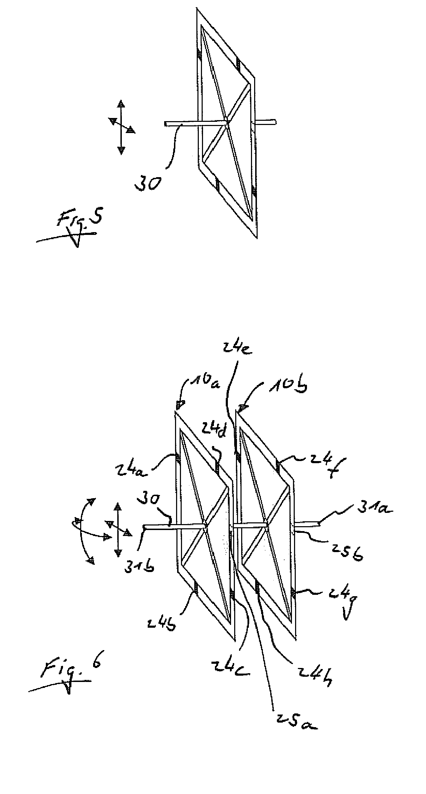

Fig. 4 and 5 depict another actuator 10 which is produced in a similar way and which is more dynamic in the degrees of free movement. This device consists of a supporting frame 11, compliant front electrodes 20a...20d and a back electrode (not shown), flexible electrical interconnections 24a...24d and a central holder 14. This device is a full-planar actuator 10 with motions possible in the directions marked A-D by applying the appropriate voltage to the appropriate front electrodes 24a... 24d and the back electrode. For example, motion in direction A is achieved by placing a voltage potential at interconnections 24b and 25. Motion in the quadrant spanned by A and B arrows is achieved by applying voltages to interconnections 24a, 24b and 25. These voltage levels can be non-identical allowing the central holder 14 to take any position in the A-D quadrant. Similarly for the B-C quadrant, applying voltages to 24c and 24d with respect to the common back electrode allow the central holder 14 to take any position in this quadrant. This provides a full range of motions about the neutral position of the central holder 14.

This actuator 10 of Fig. 4 could be used as depicted in Fig. 5 to align a micro-optical component in all the directions depicted where the micro-optical component could be an optical fiber 30. The component could however also be a supporting or mounting structure for another micro-optical component, or component or device.

Another positioning device having two actuators 10a and 10b is depicted in Fig. 6. The positioning device shown adds the dimension of tilt both horizontally and vertically. This device is composed of two actuators 10a and 10b which are individually identical to the device depicted in Fig. 4. Through this actuator combination a mounting beam structure 30, which has a distal end 31a and proximate end 31 b, is threaded. This component 30 can be either an optical fibre or mounting beam structure for other micro-optical components or other components. Component 30 should have a high aspect ratio.

Electrical interconnections 24a...24h for the front electrodes may be individually controlled by separate voltage sources, requiring up to 8 voltage sources. Grounding is provided via electrical interconnects 25a and 25b which may be connected to each other. The component 30 (e.g. mounting beam or fibre) can be translated in the direction planar with the actuator faces by using identical voltages on front electrodes that align with each other. For example applying identical voltages to interconnects 24b and 24h with respect to interconnects 25a and 25b, keeping all other leads at zero voltage, will result in an upwards planar motion of component 30. A tilting motion that urges the end 31 b of component 30 upwards and the end 31a downwards can be obtained by activating leads 24b and 24f with identical voltage potentials. By individual control of interconnections 24a... 24h the ends 31a and 31b may take a number of positions in the plane of the actuators 10a, 10b as well as being tilted. Through this full planar-translational positioning and tilting is provided and this could be used to optimise the coupling of light coming into or being coupled out of the ends of an optical fibre or an optical component mounted in the holders 14a and 14b. The actuators 10a and 10b may have identical or different electrode layouts or inner or outer frame contours or centre pieces.

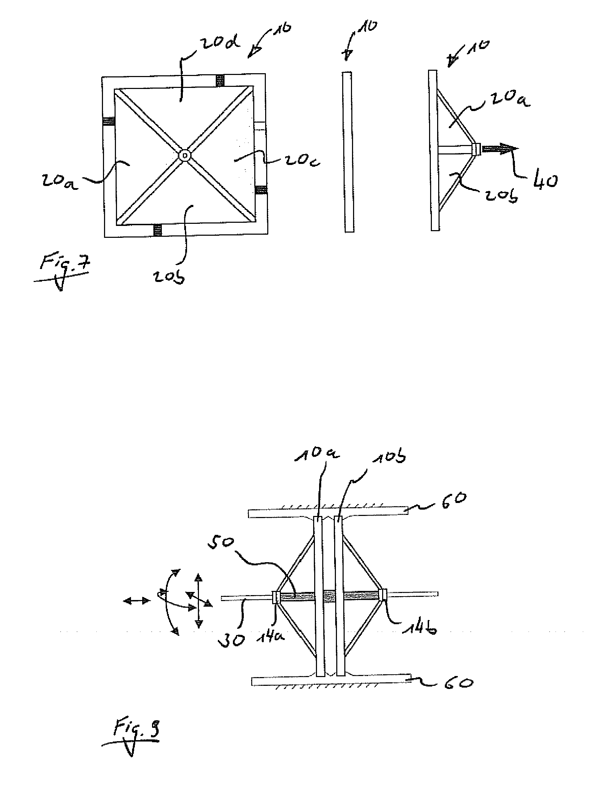

Fig. 7 illustrates another actuator 10 in a frontal view and two side views. The actuator 10 allows motion perpendicular to the plane of the actuator 10 and/or along the direction of a fibre or supporting beam. The actuator 10 as described in Fig. 4 is adapted as follows. A force 40 is applied to the central holding member 14 of the actuator 10 to cause a distension of the dielectric film 12 and the corresponding front electrodes 20a... 20d in a direction parallel to force 40 and perpendicular to the plane of the actuator 10 resulting in a distended actuator construction. In other words, the dielectric film 12 has a pyramidal or cone-shaped structure, wherein the through-hole respectively the holding members represent a top of the structure and the frame provides a basis of the structure.

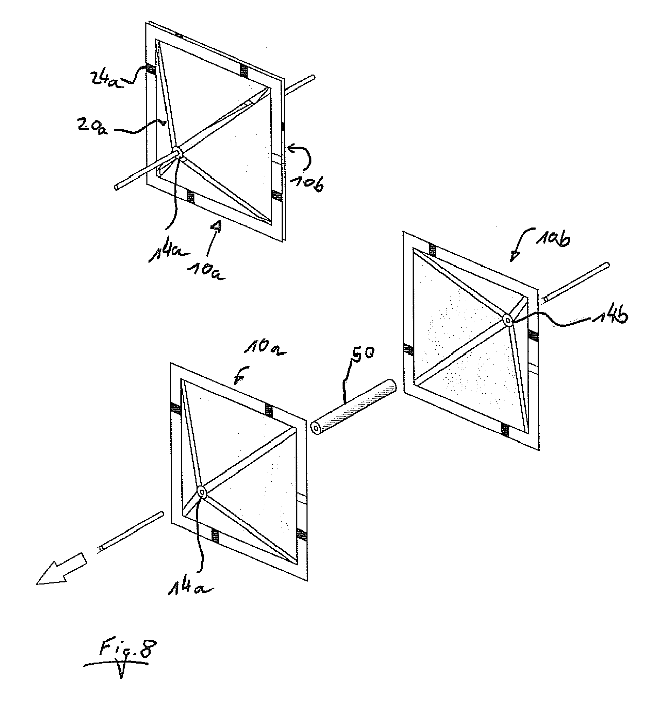

Two actuators 10a and 10b as illustrated in Fig. 7 may be placed back to back, see Fig. 8 and 9. The distension of the two actuators 10a and 10b may be maintained via a support tube 50 or the actuators 10a, 10b may be fixed to a component 30, which may intersect the actuators 10a, 10b through centre holding members 14a, 14b. The component 30 may be an optical fibre or a mounting structure for another micro-optical component. The actuators 10a, 10b may have identical or different electrode layouts or inner or outer frame contours or centre pieces. The actuators 10a, 10b may be fixed to an outer holding frame 60.

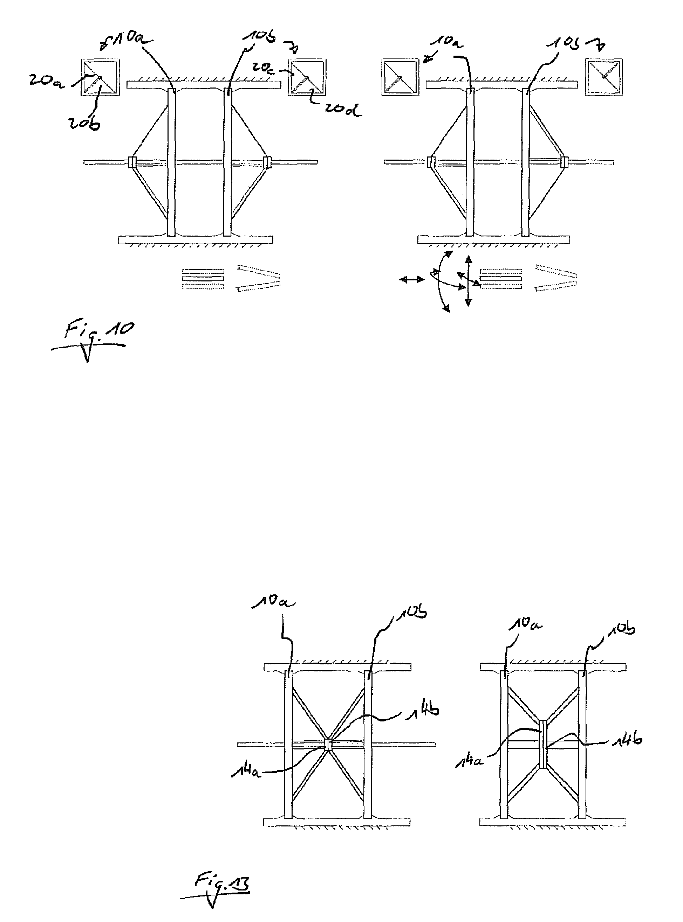

The tube 50 is not necessary if the holding members 14a, 14b are securely fixed to the component 30. This device provides all the motions described in relation to the device in Fig. 9, however, further motion is achievable long the direction of the component 30. This is achieved by activating all of the electrodes of the left or right actuators 10a, 10b which will cause a component of force to be applied to the component 30 along its length. Fig. 10 depicts two alternative alignments of distended actuators 10a, 10b each having two triangular front electrodes 20a...20d covering together a half of the dielectric film 12.

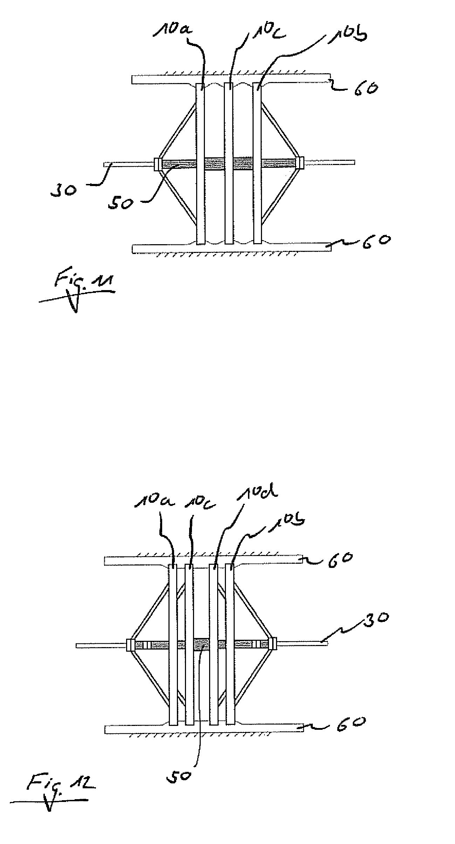

The device may be further modified and improved by adding another actuator 10c, which is not distended, into the device between the two distended actuators 10a, 10b as depicted in Fig. 11. Thereby, a force in the planar directions perpendicular to the component 30 is increased.

Adding further none-distended actuators 10c and 10d will lead to a device with the same degrees of freedom as that depicted in Fig. 11 but with increased force generation in the direction parallel to the component 30; cf. Fig. 12. Using this arrangement, a set of control voltages can be used to control the position of a micro-optical component, sub-mount or other component with high aspect ratio. Furthermore, this device has inherent sensing capabilities which can be used to monitor the position of the component held in the central holder member 14c. If component 30 is mechanically forced from it's equilibrium position by an external force this will change the capacitance of the electrodes which is a means also to sensing external forces applied to the fibre, sub-mount or other component in all translational directions (3D) and angularly. This makes this system an inherently "smart system" in that it can control it's own position while sensing changes in position that are due to an external force.

Fig. 13 illustrates another embodiment of the invention. Here, the actuators 10a, 10b having multiple electroded areas are forced from each other using outer frames 60 or other external fixtures, and the holder members 14a, 14b of the actuators 10a, 10b are forced together, using screws or glue or other. The holder members 14a, 14b thus form a platform onto which devices can be brought, such as described elsewhere. The size of the platform can be varied, for alterations in the control possibilities.

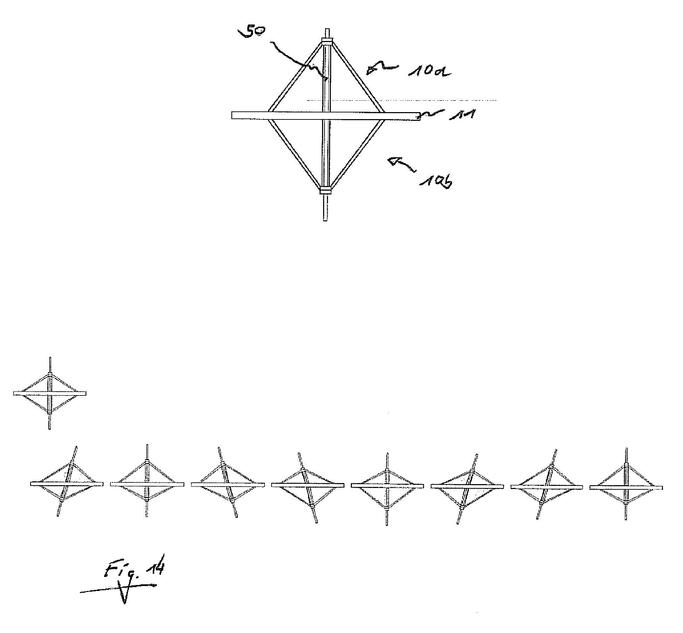

According to another embodiment of the invention, the frames of two distended actuators 10a, 10b, are fit together to provide a common frame 11 as illustrated in Fig. 14. Again the distension of the two actuators 10a and 10b is maintained via a support tube 50.

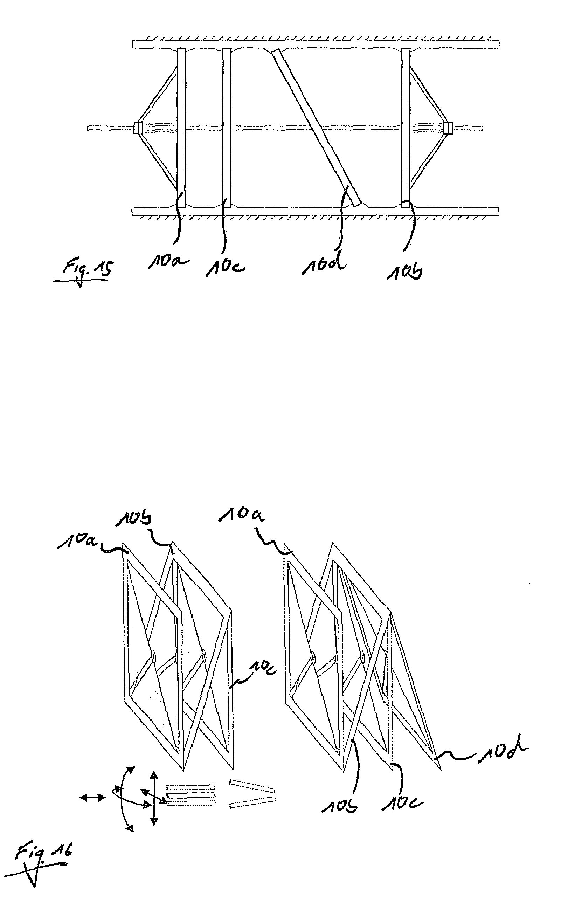

Fig. 15 depicts another positioning device including four actuators 10a...10d being positioned in line. The outermost actuators 10a, 10b are distended and one of the actuators 10c, 10d has been arranged in an inclined position.

In the embodiment as illustrated on the left side of Fig. 16, the positioning device includes three actuators 10a...10c, wherein the middle actuator 10b has been arranged in an inclined position. The second embodiment shown in Fig. 16 comprises four actuators 10a...10d. The actuators 10b and 10d are in an inclined arrangement such that they both extend to the top of the actuator 10c.

In summary, using these devices it is possible to create an positioning system for optical components. An example of how this would work is in the alignment of an optical fibre to a laser source. These two components have an optimal position relative to each other which should be achieved in order to maximise the light intensity coupled from the source into the fiber. The optical output from the fibre can be monitored and used to provide information on the state of alignment between the fibre and source. By monitoring this optical signal in an active feedback loop that controls the electrical voltage on the electrodes, this voltage can be used to align the optical components to achieve maximum coupling. In addition to this, externally applied forces such as those due to obstructions to the motion or other forces can be monitored using capacitance sensing. This "auto-aligning" system could be used in the manufacture of optical modules which contain single mode micro-optical components to realign components that have been rapidly and approximately placed with lower accuracy.

Furthermore, for more general positioning applications an optical signal can be used to sense and provide information on the state of positioning. This optical signal could take the form of an optical image which monitors the position of the device but could also be an embedded signal such as a laser or LED which can be detected and actively monitored as a function of actuator position.

**Claims**

1. A positioning device comprising:

   (i) at least one actuator (10, 10a...10d) including

   - a dielectric elastomer film (12);
   - a frame (11) adapted for supporting the film (12);
   - a through-hole placed in a central region of the film (12);
   - one or more compliant front electrodes (20, 20a...20d) applied planar to a front side of the film (12) and one or more compliant back electrodes applied planar to a back side of the film (12), wherein each one of the front electrodes (20, 20a...20d) is configured such that a circular section of the film (12) starting from the through-hole is not applied to said one front electrode (20, 20a...20d):

   and

   (ii) a circuit electrically connected to the front and back electrodes of the at least one actuator (10, 10a...10d) and being adapted for applying a voltage across the film (12) via the front and back electrodes.

2. The positioning device of claim 1, wherein the actuator (10, 10a...10d) includes 4 front electrodes (20a... 20d) extending form the through-hole in equally sized circular sections.

3. The positioning device of claim 1 or 2, wherein the positioning device includes at least 2 actuators (10a...10d) being arranged in line.

4. The positioning device of any of the preceding claims, wherein the dielectric elastomer film (12) is pre-strained.

5. The positioning device of any of the preceding claims, wherein the circuit is electrically connected to the front and back electrodes via flexible interconnections (24, 24a... 24h, 25, 25a, 25b).

6. The positioning device of any of the preceding claims, wherein the dielectric film (12) and the corresponding front electrodes (20a...20d) are distended in a direction perpendicular to the plane of the actuator (10).

7. The positioning device of any of claim 6, wherein the positioning device includes two distended actuators (10c, 10d) placed back to back.

8. The positioning device of any of claim 6, wherein the positioning device includes two distended actuators (10c, 10d) and the tops of the distended actuators (10c, 10d) are forced together.

9. Use of the positioning device of any of claims 1 through 8 for the positioning of optical fibres in telecommunication modules or other optical packages.

10. Use of the positioning device of any of claims 1 through 8 in medical devices.

11. Use of the positioning device of any of claims 1 through 8 in adaptive optics applications or switching applications.

12. Use of the positioning device of any of claims 1 through 8 in an apparatus for position sensing of an object.

13. Use of the positioning device of any of claims 1 through 8 for the positioning of an object for any purpose.

Fig. 1

Fig. 4

12

10

11

A

O

14

Fig.2

24    20    25

24a

20a

A

E

25

20b    24b

Fig.3

Fig. 5

30

Fig. 6

24e

10a

10b

24d

24a

24f

30

31a

25b

31b

24g

24b

24c

24h

25a

Fig. 8

Fig. 7

Fig. 8

10a    10c    10b

30    50    60    60

Fig. 11

10a  10c    10d    10b    60

30

50    60    60

Fig. 12

Fig. 10

Fig. 13

Fig. 14

Fig. 15

10a 10c 10d 10b

10b 10a
10a 10c 10d
10b 10c

Fig. 16

EP 2 239 792 A1

Europäisches
Patentamt
European
Patent Office
Office européen
des brevets

**EUROPEAN SEARCH REPORT**

Application Number

EP 09 15 7508

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2009/020696 A (ARTIFICIAL MUSCLE INC [US]; HEIM JONATHAN R [US]; POLYAKOV ILYA [US];) 12 February 2009 (2009-02-12) * paragraphs [0033] - [0035]; figures 8,9A,9B * | 1-13 | INV. H01L41/08 G02B7/08 G02B6/42 |
| X | US 2001/035723 A1 (PELRINE RONALD E [US] ET AL) 1 November 2001 (2001-11-01) * paragraphs [0125] - [0127] * | 1 | |
| A | US 2003/218403 A1 (DUBOWSKY STEVEN [US] ET AL) 27 November 2003 (2003-11-27) * figures 30A-C * | 1-13 | |
| X | US 2008/138060 A1 (CHANG JEN-TSORNG [TW]) 12 June 2008 (2008-06-12) * paragraph [0020]; figure 3 * | 1 | |
| X | US 2007/040481 A1 (OGINO SHIGERU [JP] OGINO SHIGERU [US]) 22 February 2007 (2007-02-22) * figures 32-34 * | 1 | TECHNICAL FIELDS SEARCHED (IPC) |
| A | US 2003/063838 A1 (HAGOOD NESBITT W [US] ET AL) 3 April 2003 (2003-04-03) * the whole document * | 1-13 | H01L G02B |
| A | US 2008/265178 A1 (JOHNSTON RICHARD S [US]) 30 October 2008 (2008-10-30) * the whole document * | 1-13 | |

The present search report has been drawn up for all claims

| Place of search | Date of completion of the search | Examiner |
|---|---|---|
| The Hague | 1 September 2009 | Plouzennec, Loïg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 09 15 7508

This annex lists the patent family members relating to the patent documents cited in the above-mentioned European search report.
The members are as contained in the European Patent Office EDP file on
The European Patent Office is in no way liable for these particulars which are merely given for the purpose of information.

01-09-2009

| Patent document cited in search report | | | Publication date | Patent family member(s) | | | Publication date |
|---|---|---|---|---|---|---|---|
| WO 2009020696 | A | | 12-02-2009 | US | 2009040361 | A1 | 12-02-2009 |
| US 2001035723 | A1 | | 01-11-2001 | NONE | | | |
| US 2003218403 | A1 | | 27-11-2003 | AU | 2003304471 | A1 | 06-04-2005 |
| | | | | WO | 2005027161 | A2 | 24-03-2005 |
| US 2008138060 | A1 | | 12-06-2008 | CN | 101196601 | A | 11-06-2008 |
| US 2007040481 | A1 | | 22-02-2007 | NONE | | | |
| US 2003063838 | A1 | | 03-04-2003 | CA | 2462810 | A1 | 10-04-2003 |
| | | | | CN | 1599872 | A | 23-03-2005 |
| | | | | EP | 1444539 | A1 | 11-08-2004 |
| | | | | JP | 2005505000 | T | 17-02-2005 |
| | | | | WO | 03029871 | A1 | 10-04-2003 |
| | | | | US | 2003076604 | A1 | 24-04-2003 |
| US 2008265178 | A1 | | 30-10-2008 | WO | 2008133636 | A1 | 06-11-2008 |

EPO FORM P0459

For more details about this annex : see Official Journal of the European Patent Office, No. 12/82

19